# EUROPEAN PATENT SPECIFICATION

(11) **EP 4 391 502 B1**
(45) Date of publication and mention of the grant of the patent: **12.08.2026**
(21) Application number: 23810682.7
(22) Date of filing: 12.04.2023
(51) Int. Cl.: H04M 1/02, H05K 7/12, G06F 1/16, G06F 1/20

(54) **ELECTRONIC DEVICE**
ELEKTRONISCHE VORRICHTUNG
DISPOSITIF ÉLECTRONIQUE

(30) Priority: 25.05.2022 CN 202210576407
(43) Date of publication of application: 26.06.2024
(73) Proprietor: Honor Device Co., Ltd., Shenzhen, Guangdong 518040 (CN)
(72) Inventor: YAN, Bin, Shenzhen, Guangdong 518040 (CN); ZHOU, Guotong, Shenzhen, Guangdong 518040 (CN); YIN, Bangshi, Shenzhen, Guangdong 518040 (CN)
(74) Representative: Beder, Jens
(86) International application number: PCT/CN2023/087740
(87) International publication number: WO 2023/226608

(56) References cited:
- CN-A- 108 573 656
- CN-A- 109 167 151
- CN-A- 113 748 395
- CN-A- 114 466 553
- CN-U- 213 183 388
- US-A1- 2019 129 229

## Description

This application claims priority to Chinese Patent Application CN 117 176 842 A (Application No. 202210576407.3), filed with the China National Intellectual Property Administration on May 25, 2022 and entitled "ELECTRONIC DEVICE".

### TECHNICAL FIELD

Embodiments of this application relate to the field of terminal technologies, and in particular, to an electronic device.

### BACKGROUND

An organic light-emitting diode (Organic Light Emitting Display, OLED) display has performance such as self-luminescence, a low drive voltage, high luminous efficiency, and high definition and contrast. The organic light-emitting diode display may implement flexible display and large-area full-color display. The organic light-emitting diode display may be a flexible display. The organic light-emitting diode display is usually used for a foldable screen. The flexible display has features of being bendable and easy to carry, and is increasingly widely applied. A foldable mobile phone is used as an example. An electronic device such as the foldable mobile phone may provide a user with experience of a changeable display area. The foldable mobile phone includes a hinge, a main frame, a sub-frame, an outer-side display, and a foldable flexible display screen. Therefore, a thickness of the foldable mobile phone is greater than a thickness of a conventional bar phone. The outer-side display is disposed in the sub-frame.

The flexible display screen includes a display portion and a driver chip (Driver IC). The driver chip is configured to transmit a drive signal to the display portion, so that the display portion displays a corresponding image. To narrow a frame of the display to implement full display, the driver chip and a binding portion for disposing the driver chip are usually bent to a back surface of the display portion. In a related technology, the binding portion and the driver chip are disposed in the sub-frame. A thickness of the outer-side display is relatively large, and in a thickness direction, the binding portion and the driver chip that are located in the sub-frame occupy relatively large space in the sub-frame. Therefore, a relatively large thickness of the sub-frame needs to be designed, which is not conducive to a thin and lightweight design of the foldable mobile phone.

CN 113 748 395 A discloses an electronic device comprising a flexible display screen and a driver chip, in which the binding portion of the flexible display screen and the driver chip are disposed in the sub-frame.

CN 109 167 151 A discloses a foldable mobile phone comprising a hinge, a main frame, a sub-frame, an outer-side display and a foldable flexible display screen.

CN 108 573 656 A discloses a flexible display screen comprising a display device, a flexible substrate, a support structure and a drive chip, wherein the display device is positioned on the flexible substrate, the flexible substrate is positioned on the support structure and a groove is provided in the support structure and used to receive the drive chip.

### SUMMARY

To solve the problem of implementing a thin and lightweight design of the electronic device, embodiments of this application provide an electronic device according to the enclosed claim 1. Advantageous features of the present invention are defined in the corresponding subclaims. In the following, parts of the description and drawings referring to embodiments, which are not covered by the claims, are not presented as embodiments of the invention but as examples useful for understanding the invention.

According to a first aspect of this application, an electronic device is provided. The electronic device includes at least a housing, a first display, and a second display.

The housing includes a first frame, a second frame, and a hinge. The hinge is connected to the first frame and the second frame. The first frame includes a first support wall. The second frame includes a second support wall. The first display includes a display portion, a binding portion, and a driver chip. The display portion is connected to the first support wall and the second support wall. The binding portion is disposed in the first frame. The driver chip is disposed in the binding portion. The binding portion is at least partially disposed between the first support wall and the display portion. The second display is disposed in the second frame. When the first frame and the second frame are in a folded state, the display portion is located between the first frame and the second frame, and the second display is located on a side that is of the second frame and that faces away from the first frame. When the first frame and the second frame are in an unfolded state, the display portion is unfolded.

According to a second aspect of this application, an electronic device is provided. The electronic device includes at least a housing, a first display, and a processor.
The housing includes a first frame, a second frame, and a hinge. The hinge is connected to the first frame and the second frame. The first frame includes a first support wall. The second frame includes a second support wall. The first display includes a display portion, a binding portion, and a driver chip. The display portion is connected to the first support wall and the second support wall. The binding portion is disposed in the first frame. The driver chip is disposed in the binding portion. The binding portion is at least partially disposed between the first support wall and the display portion. The processor is disposed in the first frame. When the first frame and the second frame are in a folded state, the display portion is located between the first frame and the second frame. When the first frame and the second frame are in an unfolded state, the display portion is unfolded.

In this embodiment of this application, the electronic device includes the first frame and the second frame. The first frame and the second frame may be close to or far away from each other, to implement folding or unfolding. The first display is disposed in the first frame and the second frame. The display portion of the first display is disposed on the first support wall and the second support wall. The binding portion and the driver chip of the first display are disposed in the first frame, so that space between the first support wall and the display portion can be fully used. Therefore, the first display can occupy relatively small space in the second frame, to save space in the second frame in a thickness direction. The space saved in the second frame may be used to reduce an overall thickness of the second frame, to help reduce a thickness of the electronic device in a folded state or an unfolded state, so as to implement a thin and lightweight design of the electronic device.

In a possible implementation, the driver chip is disposed on a side that is of the binding portion and that faces the first support wall. The first support wall includes a first accommodation portion. The first accommodation portion avoids the driver chip.

The driver chip may reuse space occupied by the first support wall, to help further reduce overall space occupied by the first support wall, the binding portion, and the driver chip in the thickness direction, so that without changing a thickness of the first frame, the binding portion and the driver chip can be disposed by fully using space in the first frame.

The first accommodation portion penetrates through the first support wall. The first frame further includes a separation part. The separation part is disposed corresponding to the driver chip. The separation part is at least partially located in the first accommodation portion. The separation part is connected to the first support wall.

In a possible implementation, the electronic device further includes a heat sink. The heat sink is connected to the first support wall. There is a first spacing between the heat sink and the driver chip.

There is the first spacing between the heat sink and the driver chip, to reduce a possibility that a region in which the heat sink laps over the driver chip occupies relatively large space in the thickness direction because the heat sink laps over the driver chip.

In a possible implementation, the heat sink is disposed facing the display portion.

In a possible implementation, the first display further includes a flexible printed circuit. The flexible printed circuit is disposed on a side that is of the display portion and that faces the first support wall. The binding portion is electrically connected to the display portion and the flexible printed circuit.

All of the binding portion, the driver chip, and the flexible printed circuit of the first display may be disposed in the first frame, so that an occupancy rate of the first display for space in the second frame can be further reduced, to save more space in the second frame.

In a possible implementation, the electronic device further includes the heat sink. The heat sink is at least partially disposed between the first support wall and the flexible printed circuit.

The heat sink may dissipate heat generated by the flexible printed circuit to the outside of the electronic device in a timely manner, so that an ambient temperature at a position of the flexible printed circuit falls within a normal working temperature range, to help ensure that an electronic component and the display portion work stably.

In a possible implementation, an area of an orthographic projection of the heat sink on the first support wall is S. The orthographic projection of the heat sink on the first support wall and an orthographic projection of the flexible printed circuit on the first support wall form an overlapping region, and an area of the overlapping region is greater than or equal to S/2.

In a possible implementation, the flexible printed circuit includes a substrate and an electronic component. An orthographic projection of the electronic component on the first support wall does not overlap the orthographic projection of the heat sink on the first support wall.

The electronic component may not be disposed in a region that is on the substrate and that is located between the heat sink and the display portion, to help reduce a possibility that the electronic component and the heat sink occupy relatively large space in the thickness direction because the electronic component and the heat sink are stacked.

In a possible implementation, the first support wall further includes a second accommodation portion. The heat sink is at least partially located in the second accommodation portion.

The heat sink is at least partially located in the second accommodation portion, so that the heat sink can reuse the space occupied by the first support wall, to help further reduce space occupied by a stacked structure of the first support wall and the heat sink in the thickness direction, so that without changing the thickness of the first frame, the heat sink can be disposed by fully using the space in the first frame.

In a possible implementation, the second accommodation portion penetrates through the first support wall. An edge region of the heat sink is connected to the first support wall.

In a possible implementation, the electronic device further includes a first circuit board. The first circuit board is disposed in the first frame. The first circuit board is located on a side that is of the first support wall and that faces away from the display portion. The flexible printed circuit is electrically connected to the first circuit board. The flexible printed circuit includes the substrate and the electronic component. Orthographic projections of at least some electronic components on the first support wall do not overlap an orthographic projection of the first circuit board on the first support wall, to help reduce a possibility that it is not easy to simultaneously dispose an electronic element in a region that is on the first circuit board and that corresponds to the electronic component because the electronic component and the first circuit board are stacked, and consequently area utilization of the first circuit board is reduced.

In a possible implementation, the electronic device further includes a rear-facing camera module. The rear-facing camera module is disposed on the side that is of the first support wall and that faces away from the display portion. The flexible printed circuit includes the substrate and the electronic component, and the electronic component is disposed between the display portion and the rear-facing camera module.

The electronic component in the flexible printed circuit may be disposed between the display portion and the rear-facing camera module, so that space between the rear-facing camera module and the display portion is fully used.

In a possible implementation, the electronic device further includes a front-facing camera module. The front-facing camera module is disposed in the first frame. The first display includes a light transmission portion. The light transmission portion is disposed corresponding to the front-facing camera module. The orthographic projection of the flexible printed circuit on the first support wall does not overlap an orthographic projection of the light transmission portion on the first support wall. The flexible printed circuit may avoid the light transmission portion of the first display, to help reduce a possibility that a region in which the electronic component and the front-facing camera module are stacked occupies relatively large space in the thickness direction because the electronic component in the flexible printed circuit and the front-facing camera module are stacked.

In a possible implementation, the display portion includes an edge region that is located on the first frame and that is far away from the hinge, and the edge region of the display portion is connected to the binding portion.

The electronic device further includes a first battery. The first battery is disposed in the first frame. The first battery is disposed on the side that is of the first support wall and that faces away from the display portion. The binding portion is at least partially located on a side that is of the first battery and that faces the display portion.

In a possible implementation, the electronic device further includes an antenna radiator. The antenna radiator is disposed in the first frame. There is a second spacing between the binding portion and the antenna radiator, to leave a clearance area for the antenna radiator, and ensure that the antenna radiator has a good omnidirectional communication effect.

In a possible implementation, the electronic device further includes a first shielding portion and a second shielding portion. The first shielding portion is disposed in an edge region that is of the first frame and that is far away from the hinge. The second shielding portion is disposed in an edge region that is of the second frame and that is far away from the hinge. A width of the first shielding portion is greater than a width of the second shielding portion.

### BRIEF DESCRIPTION OF DRAWINGS

FIG. 1 is a schematic diagram of a structure of an electronic device in an unfolded state according to an embodiment of this application;
FIG. 2 is a schematic diagram of a structure of the electronic device shown in FIG. 1 in a semi-folded state;
FIG. 3 is a schematic diagram of a structure of the electronic device in FIG. 1 in a folded state;
FIG. 4 is a schematic diagram of a partially exploded structure of the electronic device in FIG. 1;
FIG. 5 is a schematic diagram of a partial structure of a first display according to an embodiment of this application;
FIG. 6 is a schematic diagram of a partial cross-sectional structure of an electronic device according to an embodiment of this application;
FIG. 7 is a schematic diagram of a partial cross-sectional structure of an electronic device according to an embodiment that does not relate to the subject matter of the enclosed claims;
FIG. 8 is a schematic diagram of a partial cross-sectional structure of an electronic device according to still another embodiment of this application;
FIG. 9 is a schematic diagram of a partial cross-sectional structure of an electronic device according to still another embodiment of this application;
FIG. 10 is an enlarged schematic view of a position A in FIG. 6;
FIG. 11 is a schematic diagram of a partial cross-sectional structure of an electronic device according to yet another embodiment of this application;
FIG. 12 is a schematic diagram of a partial structure of an electronic device according to an embodiment of this application; and
FIG. 13 is a schematic diagram of a structure of an electronic device in an unfolded state according to another embodiment of this application.

### Reference numerals:

10: Electronic device;
20: Housing;
21: First frame; 211: First support wall; 211a: First accommodation portion; 211b: Second accommodation portion; 211c: Pocket hole; 211d: Support surface; 212: First rear cover; 213: Separation part;
22: Second frame; 221: Second support wall; 222: Second rear cover;
23: Hinge;
30: First display;
31: Display portion; 311: First display region; 312: Second display region; 313: Third display region;
32: Binding portion; 32a: Bent section;
33: Driver chip;
34: Backplane;
35: Flexible printed circuit; 351: Substrate; 352: Electronic component; 353: Electrical connector;
36: Light transmission portion;
40: Second display;
50: Rear-facing camera module;
60: Front-facing camera sensor;
70: Heat sink;
80: First circuit board; 801: Avoidance hole;
90: Adapter circuit board;
100: Second circuit board;
200: Front-facing camera module;
300: First battery;
400: Second battery;
500: Antenna radiator;
600: First shielding portion;
700: Second shielding portion;
800: Processor; and
Z: Thickness direction

### DESCRIPTION OF EMBODIMENTS

An electronic device in the embodiments of this application may be referred to as user equipment (user equipment, UE), a terminal (terminal), or the like. For example, the electronic device may be a mobile terminal or a fixed terminal such as a tablet computer (portable android device, PAD), a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self-driving (self driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home). A form of the terminal device is not specifically limited in the embodiments of this application.

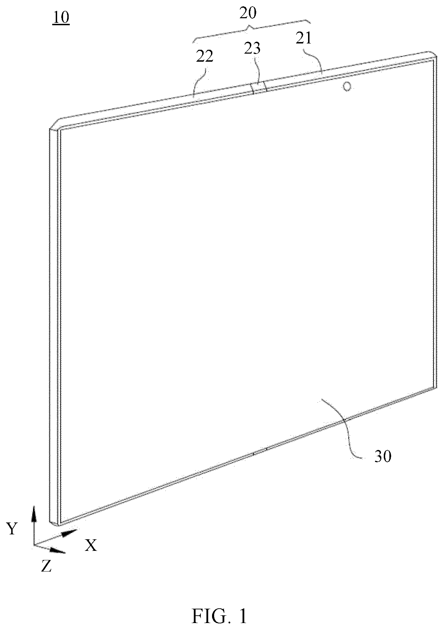

In an embodiment of this application, FIG. 1 schematically shows a structure of an electronic device 10. As shown in FIG. 1, an example in which the electronic device 10 is a handheld device with a wireless communication function is used for description. For example, the handheld device with a wireless communication function may be a mobile phone. For example, the mobile phone may be a foldable mobile phone including a foldable display.

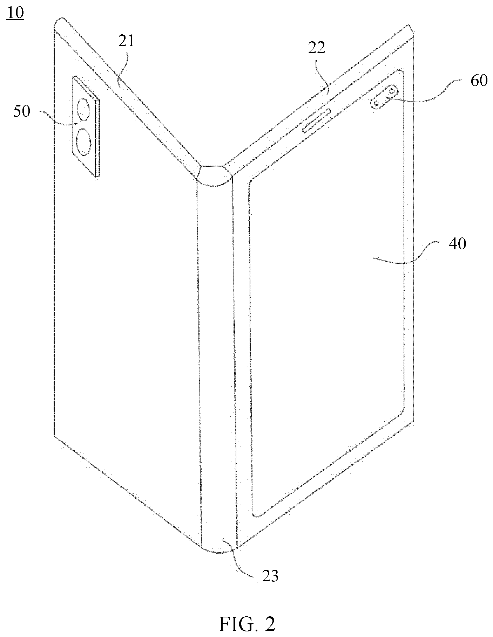

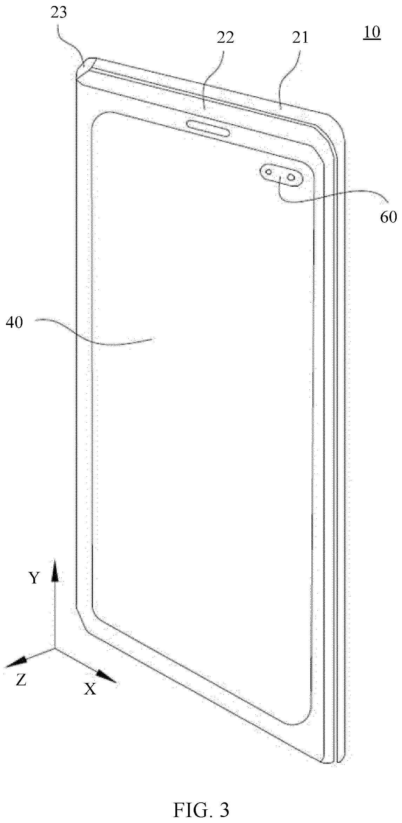

FIG. 2 schematically shows a structure of the electronic device 10 in a semi-folded state. FIG. 3 schematically shows a structure of the electronic device 10 in a folded state. As shown in FIG. 2 and FIG. 3, the electronic device 10 includes a housing 20, a first display 30, and a second display 40.

The housing 20 includes a first frame 21, a second frame 22, and a hinge 23. The first frame 21 may be used as a main frame of the electronic device 10, and the second frame 22 may be used as a sub-frame of the electronic device 10. The first frame 21 and the second frame 22 are respectively located on two sides of the hinge 23. Each of the first frame 21 and the second frame 22 is connected to the hinge 23. For example, each of the first frame 21 and the second frame 22 may be connected to the hinge 23 through welding or fastener locking or in another manner. Each of the first frame 21 and the second frame 22 may rotate and be folded relative to the hinge 23. When the first frame 21 and the second frame 22 are stacked, the electronic device 10 is in the folded state. When the first frame 21 and the second frame 22 move away from each other from a stacked state and are unfolded, the electronic device 10 is in an unfolded state. A process in which the first frame 21 and the second frame 22 change from a folded state to an unfolded state is an unfolding process, and a process in which the first frame 21 and the second frame 22 change from the unfolded state to the folded state is a folding process. For example, there may be one first frame 21 and one second frame 22. When the electronic device 10 is in the folded state, the first frame 21 and the second frame 22 are stacked to present a state of a two-layer structure.

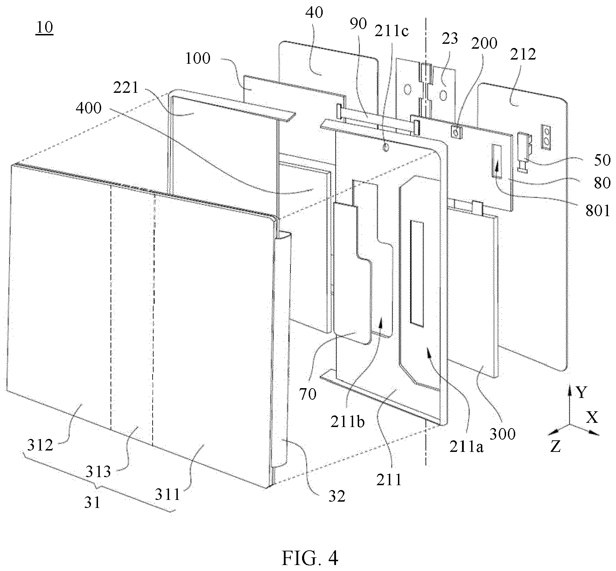

In some implementable manners, FIG. 4 schematically shows a partially exploded structure of the electronic device 10. As shown in FIG. 2 and FIG. 4, the first frame 21 includes a first support wall 211 and a first rear cover 212. Space in which another component (for example, a circuit board, a sensor, or a battery) may be disposed is formed between the first support wall 211 and the first rear cover 212. In some examples, the electronic device 10 includes a rear-facing camera module 50. The rear-facing camera module 50 is disposed in the first frame 21. The rear-facing camera module 50 may be exposed to the first rear cover 212 and may be observed.

In some implementable manners, as shown in FIG. 2 to FIG. 4, when the electronic device 10 is in the folded state, the first support wall 211 and a second support wall 221 are stacked. The second display 40 and the rear-facing camera module 50 may be respectively located on a front surface and a back surface of the electronic device 10. A user may operate the electronic device 10 by using the second display 40 or observe image information displayed on the second display 40.

In some examples, the second display 40 may be a liquid crystal display or an OLED display. This is not specifically limited in this application.

In some examples, a thickness of the second display 40 may be greater than a thickness of the first rear cover 212. For example, a difference between the thickness of the second display 40 and the thickness of the first rear cover 212 is greater than or equal to 0.3 mm. For example, the difference between the thickness of the second display 40 and the thickness of the first rear cover 212 may be 0.3 mm or 0.4 mm.

In some implementable manners, a material of the first support wall 211 may be a metal material, for example, may be but is not limited to steel, stainless steel, magnesium alloy, aluminum alloy, or titanium alloy, and a material of the second support wall 221 may be a metal material, for example, may be but is not limited to steel, stainless steel, magnesium alloy, aluminum alloy, or titanium alloy. In some other implementable manners, a material of the first support wall 211 may be plastic, and a material of the second support wall 221 may be plastic.

As shown in FIG. 4, the first display 30 includes a display portion 31 configured to display image information. The display portion 31 may be disposed on the first support wall 211 and the second support wall 221. The first display 30 may be used as an inner-side display of the electronic device 10. When the electronic device 10 is in the unfolded state, the display portion 31 of the first display 30 is exposed to facilitate presentation of image information to the user. The display portion 31 includes a first display region 311, a second display region 312, and a third display region 313. The first display region 311 is disposed corresponding to the first support wall 211. The second display region 312 is disposed corresponding to the second support wall 221. The second display 40 is located on a side that is of the second support wall 221 and that faces away from the second display region. The third display region 313 is disposed corresponding to the hinge 23. The first display 30 may be a flexible display. The first display 30 has bendable performance, and may be folded when being subjected to external force.

When the first frame 21 and the second frame 22 are in the folded state, the first support wall 211 and the second support wall 221 are stacked. Correspondingly, the display portion 31 is in a bent state, and the display portion 31 is located between the first frame 21 and the second frame 22. The second display 40 is located on a side that is of the second frame 22 and that faces away from the first frame 21. The first display region 311 and the second display region 312 of the display portion 31 are stacked, and the third display region 313 may be bent into an arc-shaped state.

When the first frame 21 and the second frame 22 are in the unfolded state, the first support wall 211 and the second support wall 221 may be in an unfolded state. Correspondingly, the display portion 31 is in an unfolded state, and the first display region 311, the second display region 312, and the third display region 313 are in a flat state. When the display portion 31 of the first display 30 is in the unfolded state, overall good flatness is achieved. In some implementable manners, the display portion 31 of the first display 30 may be of an equal-thickness structure, so that thicknesses at different positions on the display portion 31 are well consistent.

An overall size of the electronic device 10 may be changed through folding or unfolding, and there may be a relatively large display area in the unfolded state. In some scenarios of using the electronic device 10, for example, in a scenario in which the electronic device 10 is in a state of being carried, the electronic device 10 is usually in the folded state. Therefore, an overall thickness size of the electronic device 10 in the folded state greatly affects convenience and experience of a use process.

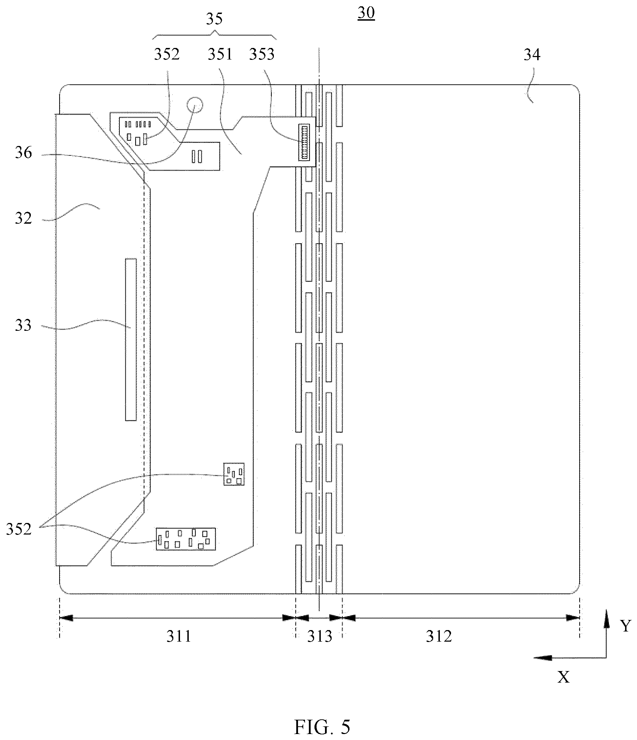

In some implementable manners, FIG. 5 schematically shows a partial structure of the first display 30 according to this application. As shown in FIG. 4 and FIG. 5, the first display 30 further includes a backplane 34. The display portion 31 of the first display 30 is stacked with the backplane 34. The backplane 34 may be connected to the first support wall 211 or the second support wall 221. The display portion 31 of the first display 30 is disposed on a side that is of the backplane 34 and that faces away from the first support wall 211. The backplane 34 may provide good support for the display portion 31, to ensure that the display portion 31 has good flatness and is not prone to depressed deformation when the display portion 31 is subjected to external force, so as to reduce a depressed deformation amount of the display portion 31.

In some implementable manners, the backplane 34 is a rigid structural member. A material of the backplane 34 may be but is not limited to copper, copper alloy, stainless steel, carbon fiber, titanium, or titanium alloy. For example, the material of the backplane 34 may be titanium or titanium alloy. The backplane 34 has a relatively small thickness, so that the backplane 34 can be easily bent and deformed. Therefore, when the first display 30 is applied to the foldable electronic device 10, the backplane 34 may be folded or unfolded synchronously with the display portion 31.

The first display 30 further includes a binding portion 32 and a driver chip 33. The first display 30 leads out a large quantity of signal lines through the binding portion 32. The signal line may be electrically connected to the driver chip 33. The signal line may include but is not limited to a scan line, a data line, a touch line, or a test signal line. The binding portion 32 is disposed in the first frame 21. The binding portion 32 is at least partially disposed between the first support wall 211 and the display portion 31. The binding portion 32 is disposed on a side that is of the backplane 34 and that faces the first support wall 211.

In some other implementable manners, the first display 30 may not be provided with the backplane 34. The display portion 31 may be connected to the first support wall 211 or the second support wall 221. The binding portion 32 may be disposed on a side that is of the display portion 31 and that faces the first support wall 211.

In some implementable manners, the binding portion 32 may be formed by using a COP (Chip On Panel) technology, so that the binding portion 32 includes a flexible base layer and a circuit layer that are directly led out from the display portion 31. Alternatively, the binding portion 32 may be formed by using a COF (Chip On Film) technology, that is, a flexible circuit board is electrically connected to the display portion 31, and the flexible circuit board at least partially forms the binding portion 32.

The driver chip 33 is disposed in the binding portion 32 and is located in the first frame 21. The driver chip 33 is stacked with the binding portion 32. Therefore, relatively large space is occupied in the thickness direction Z. It should be noted that the thickness direction Z may be perpendicular to a Y direction. For example, when the electronic device 10 is in the folded or unfolded state, the thickness direction Z may be a thickness direction of the first support wall 211. A direction from a bottom end to a top end of the electronic device 10 may be the Y direction. The driver chip 33 is electrically connected to the display portion 31 through the binding portion 32. The driver chip 33 may be configured to transmit a drive signal to the display portion 31, so that the display portion 31 displays corresponding image information. The driver chip 33 is disposed on the side that is of the backplane 34 and that faces the first support wall 211, so that a black frame area at an edge of the electronic device 10 can be reduced, to help increase a display area. In some implementable manners, the driver chip 33 may be formed by processing and manufacturing a wafer slice. It should be noted that a wafer is a silicon wafer used to manufacture a silicon semiconductor circuit.

In this embodiment of this application, the electronic device 10 includes the first frame 21 and the second frame 22. The first frame 21 and the second frame 22 may be close to or far away from each other, to implement folding or unfolding. The first display 30 is disposed in the first frame 21 and the second frame 22. The display portion 31 of the first display 30 is disposed on the first support wall 211 and the second support wall 221. The binding portion 32 and the driver chip 33 of the first display 30 are disposed in the first frame 21, so that space between the first support wall 211 and the display portion 31 can be fully used. Therefore, the first display 30 can occupy relatively small space in the second frame 22, to save space in the second frame 22 in the thickness direction Z. The space saved in the second frame 22 may be used to reduce an overall thickness of the second frame 22, to help reduce a thickness of the electronic device 10 in the folded state or the unfolded state, so as to implement a thin and lightweight design of the electronic device 10.

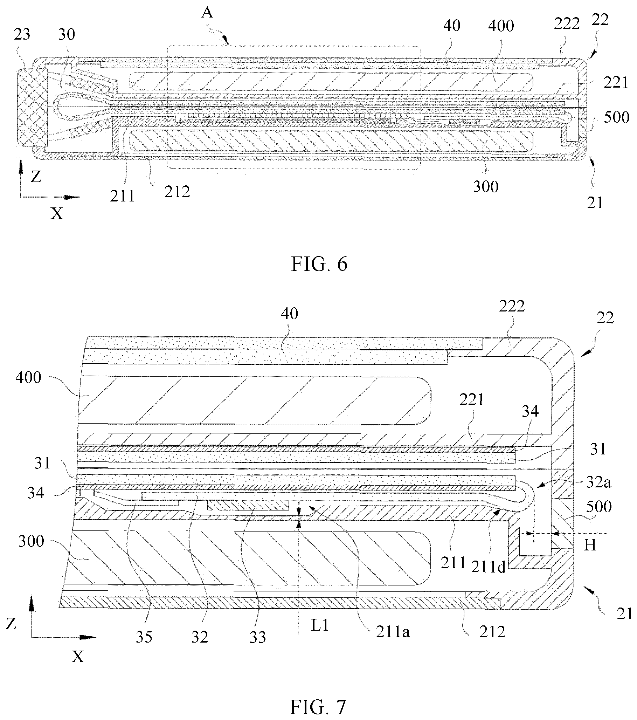

In some implementable manners, FIG. 6 schematically shows a partial cross-sectional structure of the electronic device 10 according to this application. As shown in FIG. 6, the second frame 22 includes a second support wall 221 and a second rear cover 222. Space in which another component (for example, a circuit board, a sensor, or a battery) may be disposed is formed between the second support wall 221 and the second rear cover 222. In some examples, the second display 40 has a display region for displaying image information. The display region of the second display 40 may be exposed to the second rear cover 222 and may be observed.

In some examples, the electronic device 10 further includes a front-facing camera sensor 60 (as shown in FIG. 3). The front-facing camera sensor 60 is disposed on the second rear cover 222. The front-facing camera sensor 60 may be located in an upper region of the second display 40. The front-facing camera sensor 60 is exposed to the second rear cover 222. When the electronic device 10 is in the folded state, image information may be collected by using the front-facing camera sensor 60, and the image information collected by the front-facing camera sensor 60 is displayed on the second display 40.

In some implementable manners, FIG. 7 schematically shows a partial cross-sectional structure of the electronic device 10 according to an embodiment that does not relate to the subject matter of the enclosed claims. As shown in FIG. 6 and FIG. 7, the driver chip 33 is disposed on a side that is of the binding portion 32 and that faces the first support wall 211. The first support wall 211 includes a first accommodation portion 211a. The first accommodation portion 211a has an opening close to the display portion 31. The first accommodation portion 211a avoids the driver chip 33. The driver chip 33 may reuse space occupied by the first support wall 211, to help further reduce overall space occupied by the first support wall 211, the binding portion 32, and the driver chip 33 in the thickness direction Z, so that without changing a thickness of the first frame 21, the binding portion 32 and the driver chip 33 can be disposed by fully using space in the first frame 21.

In some examples, the driver chip 33 may be at least partially located in the first accommodation portion 211a, so that the first accommodation portion 211a can avoid the driver chip 33.

In some examples, both the binding portion 32 and the driver chip 33 may be at least partially located in the first accommodation portion 211a.

In some examples, in the thickness direction Z, the first accommodation portion 211a may not penetrate through a surface that is of the first support wall 211 and that faces away from the display portion 31.

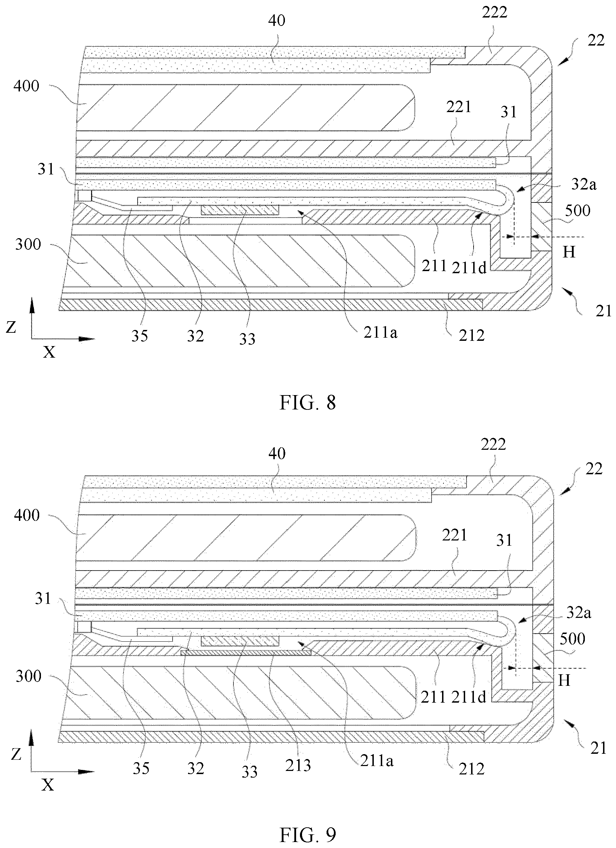

In some examples, FIG. 8 schematically shows a partial cross-sectional structure of the electronic device 10. As shown in FIG. 8, in the thickness direction Z, the first accommodation portion 211a may penetrate through two opposite surfaces of the first support wall 211. For example, the first accommodation portion 211a may include a through hole formed in a region that is on the first support wall 211 and that corresponds to the driver chip 33. The driver chip 33 is disposed corresponding to the through hole. For example, in the thickness direction Z, an orthographic projection of the driver chip 33 is located in an orthographic projection of the through hole.

For example, FIG. 9 schematically shows a partial cross-sectional structure of the electronic device 10. As shown in FIG. 9, the first frame 21 further includes a separation part 213. The separation part 213 is disposed corresponding to the driver chip 33. The separation part 213 is at least partially located in the first accommodation portion 211a. The separation part 213 is connected to the first support wall 211. The separation part 213 is located on a side that is of the driver chip 33 and that faces away from the display portion 31. The separation part 213 may be configured to shield a through hole formed after the first accommodation portion 211a penetrates through the first support wall 211. The separation part 213 separates the driver chip 33 from a structural member (the first battery 300 shown in FIG. 9) on a side that is of the first support wall 211 and that faces away from the display portion 31, to reduce a possibility that the driver chip 33 is damaged because the driver chip 33 is in contact with the structural member. In the thickness direction Z, there is a spacing between the driver chip 33 and the separation part 213. For example, a thickness of a part that is of the separation part 213 and that is located below the driver chip 33 may be a minimum thickness, to help further reduce an overall thickness of the first support wall 211 when it is ensured that the driver chip 33 is not in contact with the separation part 213.

The separation part 213 and the first support wall 211 are detachably assembled, so that the separation part 213 can be separately processed and manufactured, to help process and manufacture a separation part 213 with a smaller thickness.

For example, a material of the separation part 213 may be but is not limited to steel or stainless steel.

For example, the separation part 213 may be entirely located in the first accommodation portion 211a. An edge region of the separation part 213 may be connected to the first support wall 211 through lapping.

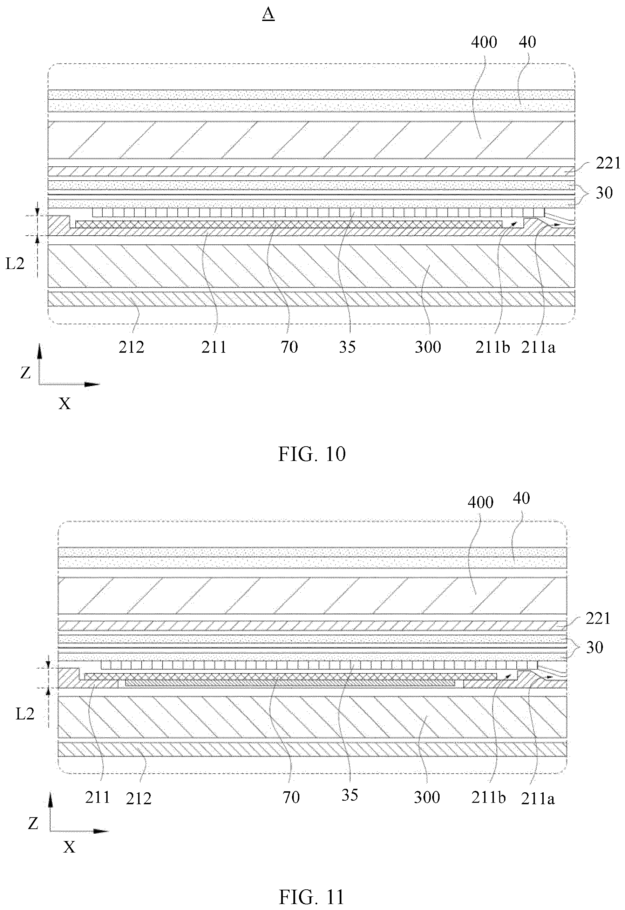

In some examples, in the thickness direction Z, a region in which the binding portion 32 and the driver chip 33 are stacked has a relatively large thickness. For example, the thickness of the region in which the binding portion 32 and the driver chip 33 are stacked may range from 0.4 mm to 0.7 mm. The first accommodation portion 211a may not penetrate through the first support wall 211. A region that is in the first accommodation portion 211a and that corresponds to the driver chip 33 has a maximum depth. Correspondingly, the region that is on the first support wall 211 and that corresponds to the driver chip 33 may have a minimum thickness L1 (as shown in FIG. 7). FIG. 10 is an enlarged view of a position A in FIG. 6. As shown in FIG. 10, a maximum thickness of the first support wall 211 is L2. For example, a region that is on the first support wall 211 and that is close to the hinge 23 may be designed to have the maximum thickness L2. A proportional relationship between the minimum thickness L1 and the maximum thickness L2 may be 0.1≤L1/L2≤0.8. In some examples, the proportional relationship between the minimum thickness L1 and the maximum thickness L2 may be L1/L2=1/7. For example, the minimum thickness L1 may be 0.1 mm, and the maximum thickness L2 may be 0.7 mm.

The region that is on the first support wall 211 and that corresponds to the driver chip 33 is used to separate the driver chip 33 and a battery (for example, a first battery 300 shown in FIG. 10), to ensure that the driver chip 33 is not prone to be pressed against the battery. Therefore, the minimum thickness L1 of the region that is on the first support wall 211 and that corresponds to the driver chip 33 needs to ensure that the region has mechanical strength that meets a requirement, and is not prone to deformation when being subjected to force in the thickness direction Z. In addition, a value of the minimum thickness L1 of the region that is on the first support wall 211 and that corresponds to the driver chip 33 affects an overall thickness design of the first support wall 211, and further affects an overall thickness design of the first frame 21. Therefore, when the minimum thickness L1 of the region that is on the first support wall 211 and that corresponds to the driver chip 33 meets a mechanical strength requirement, the minimum thickness L1 of the region that is on the first support wall 211 and that corresponds to the driver chip 33 should be designed to be relatively small.

The region that is on the first support wall 211 and that has the maximum thickness L2 needs to support the battery (for example, the first battery 300 shown in FIG. 10) and the display portion 31. A value of the maximum thickness L2 of the first support wall 211 affects the overall thickness design of the first support wall 211, and therefore affects the overall thickness design of the first frame 21. In addition, there is a positive correlation between the minimum thickness L1 of the region that is on the first support wall 211 and that corresponds to the driver chip 33 and the maximum thickness L2 of the first support wall 211. That is, a larger value of the minimum thickness L1 indicates a larger value of the maximum thickness L2. Correspondingly, a smaller value of the minimum thickness L1 indicates a smaller value of the maximum thickness L2. Therefore, when the minimum thickness L1 of the region that is on the first support wall 211 and that corresponds to the driver chip 33 meets the mechanical strength requirement, the maximum thickness L2 of the first support wall 211 should be designed to be relatively small.

In some implementable manners, a thickness of the second support wall 221 may range from 0.15 mm to 0.4 mm. For example, the thickness of the second support wall 221 may be 0.2 mm or 0.35 mm.

In some implementable manners, as shown in FIG. 10, the electronic device 10 further includes a heat sink 70. The heat sink 70 may be of a sheet-like structure. The heat sink 70 is disposed in the first frame 21. In a direction away from the hinge 23, there is a first spacing between the heat sink 70 and the driver chip 33. That is, in an X direction shown in FIG. 10, the heat sink 70 is located on one side of the driver chip 33.

An electronic element (not shown in the figure) is disposed in the first frame 21. The electronic element may include but is not limited to an antenna module, a Bluetooth module, a WiFi module, a GPS module, a charging module, a headset jack, and a USB interface. Heat generated by the electronic element is prone to accumulate in specific space. This causes a temperature rise of the electronic element and affects working performance of the electronic element. For example, in a scenario in which the user uses the electronic device 10 to play a game, play a video, or make a call for a long time, the electronic element generates a large amount of heat due to continuous working for a long time and forms a heat source. The heat sink 70 may dissipate the heat from the inside of the electronic device 10 to the outside of the electronic device 10 in a timely manner, so that an ambient temperature at a position of the electronic element falls within a normal working temperature range, to ensure that the electronic element works stably.

In some examples, the heat sink 70 may be but is not limited to a vapor chamber (VC) or a graphite sheet. In some other examples, the heat sink 70 may include a vapor chamber and a graphite sheet. The graphite sheet is disposed on the vapor chamber.

In some examples, in the thickness direction Z, a thickness of the heat sink 70 may range from 0.1 mm to 0.5 mm. For example, the thickness of the heat sink 70 may range from 0.2 mm to 0.3 mm.

In some examples, in an X direction shown in FIG. 6, the driver chip 33 is located on one side of the heat sink 70, so that there is the first spacing between the heat sink 70 and the driver chip 33, that is, in the thickness direction Z, an orthographic projection of the heat sink 70 on the first support wall 211 does not overlap an orthographic projection of the driver chip 33 on the first support wall 211, to reduce a possibility that a region in which the heat sink 70 laps over the driver chip 33 occupies relatively large space in the thickness direction Z because the heat sink 70 laps over the driver chip 33. The X direction may be a direction from a left side to a right side of the electronic device 10 when the electronic device 10 is in the unfolded or folded state.

For example, in the thickness direction Z, the orthographic projection of the heat sink 70 on the first support wall 211 partially overlaps an orthographic projection of the binding portion 32 on the first support wall 211. Alternatively, in the thickness direction Z, the orthographic projection of the heat sink 70 on the first support wall 211 does not overlap an orthographic projection of the binding portion 32 on the first support wall 211, that is, in the X direction shown in FIG. 6, the binding portion 32 is located on one side of the heat sink 70, so that there is a spacing between the heat sink 70 and the binding portion 32.

In some examples, the heat sink 70 is disposed facing the display portion 31. The heat sink 70 is located between the first support wall 211 and the display portion 31. Therefore, the heat sink 70 may be close to the first display 30, so that the heat sink 70 can dissipate heat generated by the first display 30 from the inside of the electronic device 10 to the outside of the electronic device 10 in a timely manner.

In some examples, the first support wall 211 further includes a second accommodation portion 211b. The heat sink 70 is at least partially located in the second accommodation portion 211b, so that the heat sink 70 can reuse the space occupied by the first support wall 211, to help further reduce space occupied by a stacked structure of the first support wall 211 and the heat sink 70 in the thickness direction Z, so that without changing the thickness of the first frame 21, the heat sink 70 can be disposed by fully using the space in the first frame 21.

In some examples, in the thickness direction Z, the second accommodation portion 211b may not penetrate through the surface that is of the first support wall 211 and that faces away from the display portion 31. For example, the second accommodation portion 211b may have an opening close to the display portion 31, so that the heat sink 70 disposed in the second accommodation portion 211b can face the display portion 31.

In some examples, in the thickness direction Z, a minimum thickness of a region that is on the first support wall 211 and that corresponds to the second accommodation portion 211b may range from 0.2 mm to 0.4 mm. For example, the minimum thickness of the region that is on the first support wall 211 and that corresponds to the second accommodation portion 211b may be 0.3 mm.

In some other examples, FIG. 11 schematically shows a partial cross-sectional structure of the electronic device 10. As shown in FIG. 11, in the thickness direction Z, the second accommodation portion 211b may penetrate through the two opposite surfaces of the first support wall 211, to form a through hole. The heat sink 70 is disposed corresponding to the second accommodation portion 211b. For example, an edge region of the heat sink 70 is connected to the first support wall 211. For example, the edge region of the heat sink 70 may be connected to the first support wall 211 through lapping.

In some examples, in the X direction shown in FIG. 6, the first accommodation portion 211a is disposed on a side that is of the second accommodation portion 211b and that faces away from the hinge 23. For example, the first accommodation portion 211a and the second accommodation portion 211b may not communicate with each other.

In this embodiment, the heat sink 70, the binding portion 32, and the driver chip 33 may jointly reuse space between the first support wall 211 and the display portion 31, to further improve utilization of the space in the first frame 21.

In some examples, when the electronic device 10 is in the folded state, and the overall thickness of the electronic device 10 remains unchanged, the space saved in the second frame 22 may be used to reduce the thickness of the second frame 22 and increase the thickness of the first frame 21. Therefore, thickness space by which the first frame 21 is increased may be used to increase the thickness of the heat sink 70, to improve heat dissipation efficiency of the heat sink 70 and improve heat dissipation performance of the first frame 21.

In some implementable manners, as shown in FIG. 7 and FIG. 10, the first display 30 further includes a flexible printed circuit (Flexible Printed Circuit, FPC) 35. The flexible printed circuit 35 is disposed on the side that is of the display portion 31 and that faces the first support wall 211. The binding portion 32 is electrically connected to the display portion 31 and the flexible printed circuit 35. The display portion 31 may be electrically connected to another component outside the first display 30 through the flexible printed circuit 35, to implement signal communication or data exchange.

In the electronic device 10, all of the binding portion 32, the driver chip 33, and the flexible printed circuit 35 of the first display 30 may be disposed in the first frame 21, so that an occupancy rate of the first display 30 for space in the second frame 22 can be further reduced, to save more space in the second frame 22. In some examples, the binding portion 32, the driver chip 33, the flexible printed circuit 35, and the heat sink 70 may jointly reuse the space between the first support wall 211 and the display portion 31.

In some examples, the flexible printed circuit 35 may be connected to the display portion 31. The flexible printed circuit 35 may be higher than a surface that is of the display portion 31 and that faces the first support wall 211. In some examples, a thickness of the flexible printed circuit 35 may range from 0.1 mm to 0.25 mm. For example, the thickness of the flexible printed circuit 35 may be 0.1 mm, 0.15 mm, or 0.2 mm.

In some examples, as shown in FIG. 5 and FIG. 10, the flexible printed circuit 35 includes a substrate 351 and an electronic component 352. The electronic component 352 is disposed on the substrate 351. The electronic component 352 may include but is not limited to a resistor, a capacitor, a display memory, an ESD (Electro-Static discharge) protection diode, or a pressure sensor. The flexible printed circuit 35 further includes an electrical connector 353. The flexible printed circuit 35 may be electrically connected to an external component through the electrical connector 353. For example, the electrical connector 353 may be a board to board (Board to Board, BTB) connector.

In some examples, as shown in FIG. 7 and FIG. 10, in an X direction shown in FIG. 7, the flexible printed circuit 35 has an edge region that is far away from the hinge 23. The edge region that is of the flexible printed circuit 35 and that is far away from the hinge 23 is connected to the binding portion 32. For example, there is a lapping region between the edge region that is of the flexible printed circuit 35 and that is far away from the hinge 23 and the binding portion 32. For example, the edge region that is of the flexible printed circuit 35 and that is far away from the hinge 23 may be electrically connected to the binding portion 32 by using a connection pad. For example, the first support wall 211 has the first accommodation portion 211a. The edge region that is of the flexible printed circuit 35 and that is far away from the hinge 23 may be located in the first accommodation portion 211a, to help reduce a possibility that a part at which the edge region that is of the flexible printed circuit 35 and that is far away from the hinge 23 laps over the binding portion 32 occupies relatively large space in the thickness direction Z.

In some examples, as shown in FIG. 10, the electronic device 10 further includes the heat sink 70. The heat sink 70 is at least partially disposed between the first support wall 211 and the flexible printed circuit 35. The heat sink 70 may dissipate heat generated by the flexible printed circuit 35 to the outside of the electronic device 10 in a timely manner, so that an ambient temperature at a position of the flexible printed circuit 35 falls within a normal working temperature range, to help ensure that the electronic component 352 and the display portion 31 work stably.

For example, an area of the orthographic projection of the heat sink 70 on the first support wall 211 is S. The orthographic projection of the heat sink 70 on the first support wall 211 and an orthographic projection of the flexible printed circuit 35 on the first support wall 211 form an overlapping region, and an area of the overlapping region is greater than or equal to S/2.

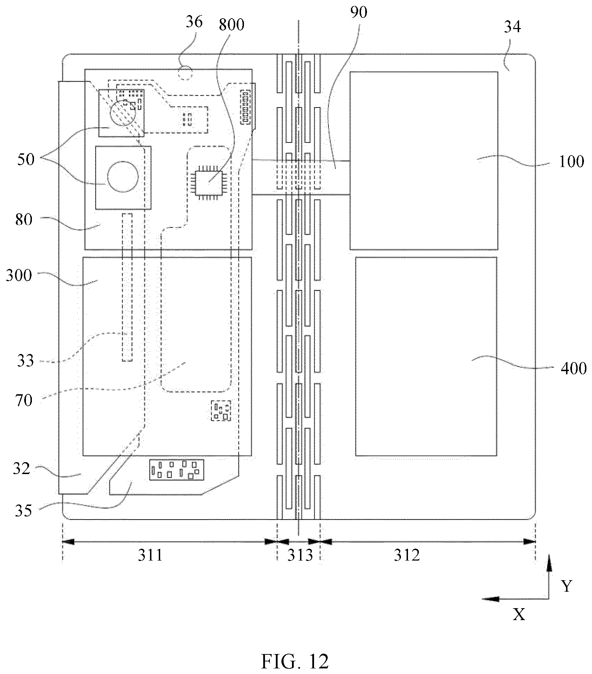

In some examples, FIG. 12 schematically shows a partial structure of the electronic device 10 according to this application. As shown in FIG. 5 and FIG. 12, an orthographic projection of the electronic component 352 in the flexible printed circuit 35 on the first support wall 211 may not overlap the orthographic projection of the heat sink 70 on the first support wall 211. The electronic component 352 is disposed on a periphery of the heat sink 70. Therefore, the electronic component 352 may not be disposed in a region that is on the substrate 351 and that is located between the heat sink 70 and the display portion 31, to help reduce a possibility that the electronic component 352 and the heat sink 70 occupy relatively large space in the thickness direction Z because the electronic component 352 and the heat sink 70 are stacked.

In some implementable manners, the electronic device 10 further includes a processor 800. The processor 800 is disposed in the first frame 21. The first display 30 is communicatively connected to the processor 800, so that the processor 800 can implement signal interaction with the first display 30. For example, the processor 800 may be a Soc (System on chip) processor. The Soc processor is a core processor in the electronic device 10. The Soc processor has a relatively strong computing capability. The first display 30 is electrically connected to the Soc processor.

In some examples, in the thickness direction Z, the orthographic projection of the heat sink 70 on the first support wall 211 overlaps an orthographic projection of the processor 800 on the first support wall 211. For example, the orthographic projection of the processor 800 on the first support wall 211 is located in the orthographic projection of the heat sink 70 on the first support wall 211.

In a scenario in which the user uses the electronic device 10 to play a game, play a video, or make a call for a long time, the processor 800 generates a large amount of heat due to continuous working for a long time and forms a heat source. The heat generated by the processor 800 is prone to accumulate in specific space. This causes a temperature rise of the processor 800 and affects working performance of the processor 800. The heat sink 70 may dissipate the heat from the inside of the electronic device 10 to the outside of the electronic device 10 in a timely manner, so that an ambient temperature at a position of the processor 800 falls within a normal working temperature range, to ensure that the processor 800 works stably.

In some implementable manners, as shown in FIG. 4 and FIG. 12, the electronic device 10 further includes a first circuit board 80. The first circuit board 80 may be used as a primary circuit board. The first circuit board 80 may be a printed circuit board (Printed Circuit Board, PCB). A bending resistance capability of the first circuit board 80 is higher than that of the flexible printed circuit 35. The first circuit board 80 is not prone to be bent when being subjected to force. The first circuit board 80 is disposed in the first frame 21. The first circuit board 80 is located on the side that is of the first support wall 211 and that faces away from the display portion 31.

In some examples, the first circuit board 80 includes the processor 800 and an electronic element (not shown in the figure). The electronic element may be electrically connected to the processor 800. The electronic element includes but is not limited to a power management chip, an antenna module, a Bluetooth module, a WiFi module, or a GPS module.

In some examples, the flexible printed circuit 35 is electrically connected to the first circuit board 80. For example, the electrical connector 353 in the flexible printed circuit 35 may be electrically connected to the first circuit board 80. The second display 40 is electrically connected to the first circuit board 80. The electronic device 10 includes an adapter circuit board 90. The second display 40 may be electrically connected to the first circuit board 80 through the adapter circuit board 90. The adapter circuit board 90 is located on a side that is of the hinge 23 and that faces the display portion 31. The adapter circuit board 90 is disposed across the hinge 23. One end of the adapter circuit board 90 is disposed in the first frame 21, and the other end is disposed in the second frame 22. For example, the adapter circuit board 90 may be a flexible circuit board.

If the flexible printed circuit 35 electrically connected to the first display 30 is disposed in the second frame 22, and the first circuit board 80 is disposed in the first frame 21, the adapter circuit board 90 needs to cross the hinge 23 to electrically connect the flexible printed circuit 35 and the first circuit board 80. According to this embodiment, both the flexible printed circuit 35 and the first circuit board 80 are disposed in the first frame 21, so that the flexible printed circuit 35 does not need to be electrically connected to the first circuit board 80 through a signal line crossing the hinge 23. Therefore, a quantity of signal lines crossing the hinge 23 can be effectively reduced, a width of the adapter circuit board 90 at the hinge 23 can be reduced, and a possibility that difficulty in designing the hinge 23 is increased because of a relatively large width of the adapter circuit board 90 can be reduced. The width of the adapter circuit board 90 is a size measured in the X direction shown in FIG. 12. For example, the flexible printed circuit 35 does not need to be electrically connected to the first circuit board 80 through the signal line crossing the hinge 23. In this case, at least 20 signal lines may be reduced, so that a total quantity of pins (Pin) of a board to board connector on the adapter circuit board 90 can be less than or equal to 140 pins.

In some examples, in the thickness direction Z, in the flexible printed circuit 35, orthographic projections of all electronic components 352 on the first support wall 211 overlap an orthographic projection of the first circuit board 80 on the first support wall 211.

In some examples, in the thickness direction Z, in the flexible printed circuit 35, orthographic projections of at least some electronic components 352 on the first support wall 211 do not overlap the orthographic projection of the first circuit board 80 on the first support wall 211, to help reduce a possibility that it is not easy to simultaneously dispose an electronic element in a region that is on the first circuit board 80 and that corresponds to the electronic component 352 because the electronic component 352 and the first circuit board 80 are stacked, and consequently area utilization of the first circuit board 80 is reduced. For example, the first circuit board 80 includes an electronic element. In the thickness direction Z, the orthographic projection of the electronic component 352 in the flexible printed circuit 35 on the first support wall 211 does not overlap an orthographic projection of the electronic element on the first circuit board 80 on the first support wall 211.

In some examples, as shown in FIG. 4 and FIG. 12, the electronic device 10 further includes a rear-facing camera module 50. The rear-facing camera module 50 is disposed on the side that is of the first support wall 211 and that faces away from the display portion 31. The electronic device 10 may collect image information by using the rear-facing camera module 50. When the electronic device 10 is in the folded state, the image information collected by the rear-facing camera module 50 may be displayed on the second display 40. When the electronic device 10 is in the unfolded state, the image information collected by the rear-facing camera module 50 may be displayed on the first display 30.

The rear-facing camera module 50 is electrically connected to the first circuit board 80. In the thickness direction Z, there may be relatively large space between the rear-facing camera module 50 and the display portion 31. The electronic component 352 in the flexible printed circuit 35 may be disposed between the display portion 31 and the rear-facing camera module 50, so that space between the rear-facing camera module 50 and the display portion 31 is fully used, and impact of the electronic component 352 on utilization of the first circuit board 80 is reduced. For example, in the flexible printed circuit 35, some electronic components 352 may be disposed between the display portion 31 and the rear-facing camera module 50.

In some examples, there may be at least two rear-facing camera modules 50. There may be relatively large space between a rear-facing camera module 50 with a relatively small thickness (a size in the thickness direction Z) and the display portion 31. The electronic component 352 may be disposed between the rear-facing camera module 50 with a relatively small thickness and the display portion 31, to help reduce a possibility that the electronic component 352 occupies additional space in the thickness direction Z because the electronic component 352 needs to be disposed, and consequently the overall thickness of the first frame 21 is increased.

In addition, there may be relatively large space between the rear-facing camera module 50 with a relatively small thickness and the display portion 31. Therefore, the disposed electronic component 352 is not prone to interfere with a position of the rear-facing camera module 50, to help reduce a possibility that the rear-facing camera module 50 needs to move in a direction far away from the display portion 31 because the rear-facing camera module 50 needs to avoid the electronic component 352, and consequently in the thickness direction Z, a size that is of the rear-facing camera module 50 and that protrudes from the first rear cover 212 is increased.

In some examples, the first circuit board 80 has an avoidance hole 801. In the thickness direction Z, the avoidance hole 801 penetrates through two opposite surfaces of the first circuit board 80. The rear-facing camera module 50 is at least partially located in the avoidance hole 801. This helps reduce a region in which the rear-facing camera module 50 and the first circuit board 80 are stacked, and reduce a possibility that utilization of the first circuit board 80 is relatively low because of an excessively large region in which the rear-facing camera module 50 and the first circuit board 80 are stacked. In addition, some electronic components 352 may be disposed corresponding to the avoidance hole 801, to help reduce a possibility that utilization of the first circuit board 80 is relatively low because an excessively large quantity of electronic components 352 are stacked with the first circuit board 80.

In some implementable manners, the electronic device 10 further includes a second circuit board 100. The second circuit board 100 may be used as a secondary circuit board. The second circuit board 100 may be a printed circuit board (Printed Circuit Board, PCB). A bending resistance capability of the second circuit board 100 is higher than that of the flexible printed circuit 35. The first circuit board 80 is not prone to be bent when being subjected to force. The second circuit board 100 is disposed in the second frame 22. The second circuit board 100 is located on a side that is of the second support wall 221 and that faces away from the display portion 31. The second display 40 is electrically connected to the second circuit board 100. The first circuit board 80 is electrically connected to the second circuit board 100. For example, the first circuit board 80 is electrically connected to the second circuit board 100 through the adapter circuit board 90.

In some implementable manners, as shown in FIG. 4 and FIG. 12, the electronic device 10 further includes a front-facing camera module 200. The front-facing camera module 200 is disposed in the first frame 21. The front-facing camera module 200 may be electrically connected to the first circuit board 80. The first display 30 includes a light transmission portion 36. The light transmission portion 36 is disposed corresponding to the front-facing camera module 200. When the electronic device 10 is in the unfolded state, the electronic device 10 may collect image information by using the front-facing camera module 200, and may display, on the first display 30, the image information collected by the front-facing camera module 200.

In some examples, the light transmission portion 36 of the first display 30 is a light transmission hole that penetrates through the backplane 34 and the display portion 31 of the first display 30. Light arrives at a light inlet portion of the front-facing camera module 200 through the light transmission portion 36. In a case of viewing from a front surface of the first display 30, the front-facing camera module 200 may be observed.

In some examples, the light transmission portion 36 of the first display 30 is a light transmission hole that penetrates through the backplane 34 of the first display 30. The light transmission portion 36 is located below the display portion 31, so that the front-facing camera module 200 is located below the display portion 31. In a case of viewing from a front surface of the first display 30, the front-facing camera module 200 cannot be observed. Light may arrive at a light inlet portion of the front-facing camera module 200 through the display portion 31 and the light transmission portion 36.

In some examples, as shown in FIG. 4, the first support wall 211 has a pocket hole 211c, configured to avoid the front-facing camera module 200. The front-facing camera module 200 is disposed corresponding to the pocket hole 211c.

In some examples, as shown in FIG. 12, the orthographic projection of the flexible printed circuit 35 on the first support wall 211 does not overlap an orthographic projection of the light transmission portion 36 of the first display 30 on the first support wall 211, so that the flexible printed circuit 35 can avoid the light transmission portion 36 of the first display 30, to help reduce a possibility that a region in which the electronic component 352 and the front-facing camera module 200 are stacked occupies relatively large space in the thickness direction Z because the electronic component 352 in the flexible printed circuit 35 and the front-facing camera module 200 are stacked.

As shown in FIG. 7, in the X direction shown in FIG. 7, the display portion 31 includes an edge region (for example, an edge region on a right side shown in FIG. 7) that is located on the first frame 21 and that is far away from the hinge 23. The edge region that is of the display portion 31 and that is located on the first frame 21 is connected to the binding portion 32, so that the display portion 31 can lead out a signal line from the right-side region shown in FIG. 7.

In some implementable manners, the binding portion 32 includes a bent section 32a disposed close to the display portion 31. The bent section 32a may be of an arc-shaped structure, to reduce a possibility that the binding portion 32 is fractured because the binding portion 32 in a bent state is prone to stress concentration.

In some examples, in the X direction shown in FIG. 7, there is a support surface 211d at an edge that is of the first support wall 211 and that is far away from the hinge 23. The support surface 211d may be an inclined surface. The support surface 211d is disposed corresponding to the bent section 32a, to support the bent section 32a. When the inclined support surface 211d is in contact with the bent section 32a, a relatively large contact surface may be formed between the support surface 211d and the bent section 32a, to help reduce a possibility that the bent section 32a encounters stress concentration and is fractured because of a relatively small area in which the first support wall 211 presses against the bent section 32a.

In some examples, the backplane 34 of the first display 30 is located on an inner side of the bent section 32a, so that in a case of viewing from an outer side of the bent section 32a, a part of the backplane 34 is shielded by the bent section 32a.

In some implementable manners, as shown in FIG. 6 and FIG. 7, the electronic device 10 further includes a first battery 300. The first battery 300 is disposed in the first frame 21. The first battery 300 may be used as a primary battery. The first battery 300 may provide electrical energy for the first display 30, the second display 40, or another component. The first battery 300 is disposed on the side that is of the first support wall 211 and that faces away from the display portion 31. In some examples, the first battery 300 is at least partially located between the first support wall 211 and the first rear cover 212. The first rear cover 212 may be used as a battery cover.

The binding portion 32 is at least partially located on a side that is of the first battery 300 and that faces the display portion 31, so that in the thickness direction Z, there is an overlapping region between the orthographic projection of the binding portion 32 on the first support wall 211 and an orthographic projection of the first battery 300 on the first support wall 211.

In some examples, the first battery 300 generates heat due to continuous working for a long time and forms a heat source. The heat sink 70 may dissipate the heat from first battery 300 to the outside of the electronic device 10 in a timely manner, so that an ambient temperature at a position of the first battery 300 falls within a normal working temperature range, to ensure that the first battery 300 works stably.

In some implementable manners, the electronic device 10 further includes a second battery 400. The second battery 400 is disposed in the second frame 22. The second battery 400 may be used as a secondary battery. The second battery 400 may provide electrical energy for the first display 30, the second display 40, or another component. Both the first battery 300 and the second battery 400 may provide electrical energy for the electronic device 10, to help improve a life capability of the electronic device 10. The second battery 400 is disposed on a side that is of the second support wall 221 and that faces the second display 40. In some examples, the second battery 400 is at least partially located between the second support wall 221 and the second display 40.

The binding portion 32 and the driver chip 33 of the first display 30 are disposed in the first frame 21. Therefore, the first display 30 can occupy relatively small space in the second frame 22, to save space in the second frame 22 in the thickness direction Z. The space saved in the second frame 22 may improve manufacturability of the second battery 400, that is, there is enough space in the second frame 22 to dispose the second battery 400. In addition, a second battery 400 with a relatively large thickness may be disposed in the second frame 22, to help improve energy density of the second battery 400, and improve a life capability of the second battery 400.

In some examples, the second battery 400 generates heat due to continuous working for a long time and forms a heat source. The heat from the second battery 400 may be dissipated to the outside of the electronic device 10 through the second display 40 or the second rear cover 222, so that an ambient temperature at a position of the second battery 400 falls within a normal working temperature range, to ensure that the second battery 400 works stably. Therefore, an additional heat dissipation structure may not need to be disposed in the second frame 22, to help further save space.

In some implementable manners, as shown in FIG. 6 and FIG. 7, the electronic device 10 further includes an antenna radiator 500. The antenna radiator 500 is disposed in the first frame 21. There is a second spacing H between the binding portion 32 and the antenna radiator 500, to leave a clearance area for the antenna radiator 500, and ensure that the antenna radiator 500 has a good omnidirectional communication effect. The binding portion 32 includes a signal line used to transmit an electrical signal, so that when the binding portion 32 maintains the second spacing H with the antenna radiator 500, a possibility that antenna performance is degraded because the binding portion 32 causes signal interference to the antenna radiator 500 can be reduced. In some examples, a material of the antenna radiator 500 may be a metal material.

In some examples, in the thickness direction Z, an orthographic projection of the first display 30 does not overlap an orthographic projection of the antenna radiator 500. For example, there is the second spacing H between the orthographic projection of the first display 30 and the orthographic projection of the antenna radiator 500.

In some examples, in the X direction shown in FIG. 7, the antenna radiator 500 may be disposed on a side wall that is of the second frame 22 and that is far away from the hinge 23.

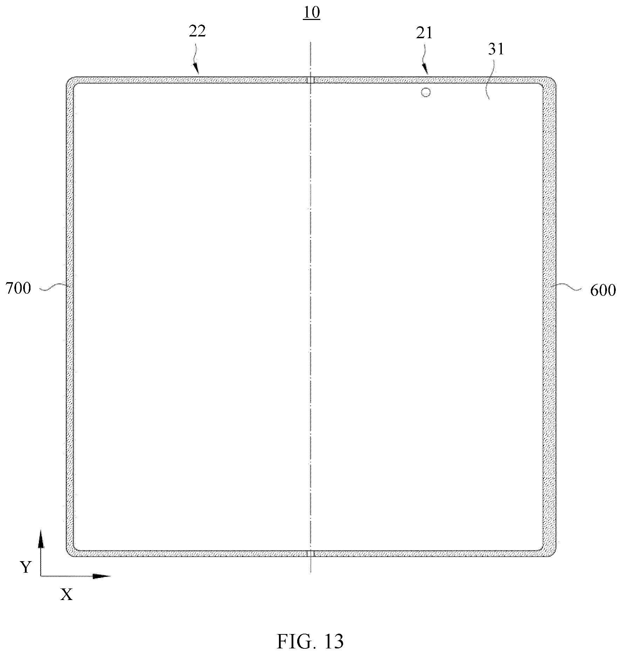

In some examples, FIG. 13 schematically shows a front structure of the electronic device 10 according to this application. As shown in FIG. 13, the electronic device 10 includes a first shielding portion 600 and a second shielding portion 700. The first shielding portion 600 is disposed in an edge region (for example, an edge region on a right side shown in FIG. 13) that is of the first frame 21 and that is far away from the hinge 23. The first shielding portion 600 may shield a corresponding edge of the display portion 31, the bent section 32a, and the antenna radiator 500. The second shielding portion 700 is disposed in an edge region (for example, an edge region on a left side shown in FIG. 13) that is of the second frame 22 and that is far away from the hinge 23. The second shielding portion 700 may shield an edge of the display portion 31.

For example, a width of the first shielding portion 600 is greater than a width of the second shielding portion 700. The width of the first shielding portion 600 and the width of the second shielding portion 700 may be sizes measured in an X direction shown in FIG. 13. A length of the first shielding portion 600 and a length of the second shielding portion 700 may be sizes measured in a Y direction shown in FIG. 13.

In the descriptions of the embodiments of this application, it should be noted that unless otherwise specified or limited, terms "mount", "connect", and "connection" shall be understood in a broad sense, for example, may be a fixed connection, may be an indirect connection by using an intermediate medium, or may be a connection between insides of two elements or an interaction relationship between two elements. A person of ordinary skill in the art may understand specific meanings of the foregoing terms in the embodiments of this application based on a specific situation.

In the embodiments of this application, it does not indicate or is not implied that an apparatus or an element needs to have a particular orientation or needs to be constructed and operated in a particular orientation, and therefore cannot be construed as a limitation on the embodiments of this application. In the descriptions of the embodiments of this application, "a plurality of" means two or more, unless otherwise specifically specified.

The terms "first", "second", "third", "fourth", and the like (if existent) in the specification, claims, and accompanying drawings of the embodiments of this application are used to distinguish between similar objects, but are not necessarily used to describe a particular order or sequence. It should be understood that the data termed in such a way is interchangeable in proper situations, so that the embodiments of this application that are described herein can be implemented in orders other than the order illustrated or described herein. In addition, the terms "include", "have", and any variation thereof are intended to cover non-exclusive inclusions. For example, a process, a method, a system, a product, or a device that includes a series of steps or units is not necessarily limited to those steps or units that are clearly listed, but may include other steps or units that are not clearly listed or are inherent to the process, method, product, or device.

The term "a plurality of" in this specification means two or more. In this specification, the term "and/or" is merely an association relationship for describing associated objects, and indicates that three relationships may exist. For example, A and/or B may indicate the following three cases: Only A exists, both A and B exist, and only B exists. In addition, the character "/" in this specification usually indicates an "or" relationship between associated objects. In a formula, the character "/" indicates that the associated objects are in a "division" relationship.

It may be understood that various numeric numbers used in the embodiments of this application are merely for differentiation for ease of description, and are not intended to limit the scope of the embodiments of this application.

It may be understood that in the embodiments of this application, sequence numbers of the foregoing processes do not mean execution sequences. The execution sequences of the processes should be determined according to functions and internal logic of the processes, and should not be construed as any limitation on the implementation processes of the embodiments of this application.

## Claims

1. An electronic device (10), comprising at least the following:
a housing (20), comprising a first frame (21), a second frame (22), and a hinge (23), wherein the hinge (23) is connected to the first frame (21) and the second frame (22), the first frame (21) comprises a first support wall (211), and the second frame (22) comprises a second support wall (221);
a first display (30), comprising a display portion (31), a binding portion (32), and a driver chip (33), wherein the display portion (31) is connected to the first support wall (211) and the second support wall (221), the binding portion (32) is disposed in the first frame (21), the driver chip (33) is disposed in the binding portion (32), and the binding portion (32) is at least partially disposed between the first support wall (211) and the display portion (31);
a second display (40), disposed in the second frame (22); and
a battery (300), disposed in the first frame (21), wherein the battery (300) is disposed on a side of the first support wall (211) facing away from the display portion (31); wherein
when the first frame (21) and the second frame (22) are in a folded state, the display portion (31) is located between the first frame (21) and the second frame (22), and the second display (40) is located on a side of the second frame (22) facing away from the first frame (21), and when the first frame (21) and the second frame (22) are in an unfolded state, the display portion (31) is unfolded;
the driver chip (33) is disposed on a side of the binding portion (32) facing the first support wall (211), the first support wall (211) comprises a first accommodation portion (211a), and the first accommodation portion (211a) avoids the driver chip (33);
the first accommodation portion (211a) penetrates through the first support wall (211), the first frame (21) further comprises a separation part (213) configured to separate the driver chip (33) from the battery (300), the separation part (213) is disposed corresponding to the driver chip (33), the separation part (213) is at least partially located in the first accommodation portion (211a), and the separation part (213) is connected to the first support wall (211); and
the first support wall (211) comprises an inclined support surface (211d) at an edge of the first support wall (211) that is far away from the hinge (23), and the inclined support surface (211d) is disposed corresponding to a bent section (32a) of the binding portion (32) to support the bent section (32a).

2. The electronic device (10) according to claim 1, wherein the electronic device (10) further comprises a heat sink (70), the heat sink (70) is connected to the first support wall (211), and there is a first spacing between the heat sink (70) and the driver chip (33).

3. The electronic device (10) according to claim 2, wherein the heat sink (70) is disposed facing the display portion (31).

4. The electronic device (10) according to any one of claims 1 to 3, wherein the first display (30) further comprises a flexible printed circuit (35), the flexible printed circuit (35) is disposed on a side of the display portion (31) facing the first support wall (211), and the binding portion (32) is electrically connected to the display portion (31) and the flexible printed circuit (35).

5. The electronic device (10) according to claim 4, wherein the electronic device (10) further comprises the heat sink (70), and the heat sink (70) is at least partially disposed between the first support wall (211) and the flexible printed circuit (35).

6. The electronic device (10) according to claim 5, wherein an area of an orthographic projection of the heat sink (70) on the first support wall (211) is S, the orthographic projection of the heat sink (70) on the first support wall (211) and an orthographic projection of the flexible printed circuit (35) on the first support wall (211) form an overlapping region, and an area of the overlapping region is greater than or equal to S/2.

7. The electronic device (10) according to claim 5 or 6, wherein the flexible printed circuit (35) comprises a substrate (351) and an electronic component (352), and an orthographic projection of the electronic component (352) on the first support wall (211) does not overlap the orthographic projection of the heat sink (70) on the first support wall (211).

8. The electronic device (10) according to claim 2, 5, 6, or 7, wherein the first support wall (211) further comprises a second accommodation portion (211b), and the heat sink (70) is at least partially located in the second accommodation portion (211b).

9. The electronic device (10) according to claim 8, wherein the second accommodation portion (211b) penetrates through the first support wall (211), and an edge region of the heat sink (70) is connected to the first support wall (211).

10. The electronic device (10) according to any one of claims 4 to 9, wherein the electronic device (10) further comprises a first circuit board (80), the first circuit board (80) is disposed in the first frame (21), the first circuit board (80) is located on a side of the first support wall (211) facing away from the display portion (31), the flexible printed circuit (35) is electrically connected to the first circuit board (80), the flexible printed circuit (35) comprises the substrate (351) and the electronic component (352), and orthographic projections of at least some electronic components on the first support wall (211) do not overlap an orthographic projection of the first circuit board (80) on the first support wall (211).

11. The electronic device (10) according to any one of claims 4 to 10, wherein the electronic device (10) further comprises a rear-facing camera module (50), the rear-facing camera module (50) is disposed on the side of the first support wall (211) facing away from the display portion (31), the flexible printed circuit (35) comprises the substrate (351) and the electronic component (352), and the electronic component (352) is disposed between the display portion (31) and the rear-facing camera module (50).

12. The electronic device (10) according to any one of claims 4 to 11, wherein the electronic device (10) further comprises a front-facing camera module (60), the front-facing camera module (60) is disposed in the first frame (21), the first display (30) comprises a light transmission portion (36), the light transmission portion (36) is disposed corresponding to the front-facing camera module (60), and the orthographic projection of the flexible printed circuit (35) on the first support wall (211) does not overlap an orthographic projection of the light transmission portion (36) on the first support wall (211).

13. The electronic device (10) according to any one of claims 1 to 12, wherein the display portion (31) comprises an edge region that is located on the first frame (21) and that is far away from the hinge (23), and the edge region of the display portion (31) is connected to the binding portion (32).

## Patentansprüche

1. Elektronische Vorrichtung (10), umfassend mindestens Folgendes:
ein Gehäuse (20), umfassend einen ersten Rahmen (21), einen zweiten Rahmen (22) und ein Scharnier (23), wobei das Scharnier (23) mit dem ersten Rahmen (21) und dem zweiten Rahmen (22) verbunden ist, wobei der erste Rahmen (21) eine erste Stützwand (211) umfasst und der zweite Rahmen (22) eine zweite Stützwand (221) umfasst;
eine erste Anzeige (30), umfassend einen Anzeigeabschnitt (31), einen Bindungsabschnitt (32) und einen Treiberchip (33), wobei der Anzeigeabschnitt (31) mit der ersten Stützwand (211) und der zweiten Stützwand (221) verbunden ist, wobei der Bindungsabschnitt (32) in dem ersten Rahmen (21) angeordnet ist, der Treiberchip (33) in dem Bindungsabschnitt (32) angeordnet ist und der Bindungsabschnitt (32) zumindest teilweise zwischen der ersten Stützwand (211) und dem Anzeigeabschnitt (31) angeordnet ist;
eine zweite Anzeige (40), die in dem zweiten Rahmen (22) angeordnet ist; und
eine Batterie (300), die in dem ersten Rahmen (21) angeordnet ist, wobei die Batterie (300) auf einer von dem Anzeigeabschnitt (31) abgewandten Seite der ersten Stützwand (211) angeordnet ist; wobei
wenn sich der erste Rahmen (21) und der zweite Rahmen (22) in einem zusammengeklappten Zustand befinden, der Anzeigeabschnitt (31) zwischen dem ersten Rahmen (21) und dem zweiten Rahmen (22) angeordnet ist und sich die zweite Anzeige (40) auf einer von dem ersten Rahmen (21) abgewandten Seite des zweiten Rahmens (22) befindet, und wenn sich der erste Rahmen (21) und der zweite Rahmen (22) in einem aufgeklappten Zustand befinden, der Anzeigeabschnitt (31) aufgeklappt ist;
der Treiberchip (33) auf einer der ersten Stützwand (211) zugewandten Seite des Bindungsabschnitts (32) angeordnet ist, wobei die erste Stützwand (211) einen ersten Aufnahmeabschnitt (211a) umfasst und der erste Aufnahmeabschnitt (211a) den Treiberchip (33) ausspart;
der erste Aufnahmeabschnitt (211a) die erste Stützwand (211) durchdringt, wobei der erste Rahmen (21) ferner ein Trennbauteil (213) umfasst, das dazu eingerichtet ist, den Treiberchip (33) von der Batterie (300) zu trennen, wobei das Trennbauteil (213) entsprechend dem Treiberchip (33) angeordnet ist, das Trennbauteil (213) sich zumindest teilweise in dem ersten Aufnahmeabschnitt (211a) befindet und das Trennbauteil (213) mit der ersten Stützwand (211) verbunden ist; und
die erste Stützwand (211) eine geneigte Stützfläche (211d) an einer Kante der ersten Stützwand (211) umfasst, die von dem Scharnier (23) beabstandet ist, und die geneigte Stützfläche (211d) entsprechend einem gebogenen Abschnitt (32a) des Bindungsabschnitts (32) angeordnet ist, um den gebogenen Abschnitt (32a) zu stützen.

2. Elektronische Vorrichtung (10) nach Anspruch 1, wobei die elektronische Vorrichtung (10) ferner einen Kühlkörper (70) umfasst, wobei der Kühlkörper (70) mit der ersten Stützwand (211) verbunden ist und ein erster Abstand zwischen dem Kühlkörper (70) und dem Treiberchip (33) besteht.

3. Elektronische Vorrichtung (10) nach Anspruch 2, wobei der Kühlkörper (70) dem Anzeigeabschnitt (31) zugewandt angeordnet ist.

4. Elektronische Vorrichtung (10) nach einem der Ansprüche 1 bis 3, wobei die erste Anzeige (30) ferner eine flexible gedruckte Schaltung (35) umfasst, wobei die flexible gedruckte Schaltung (35) auf einer der ersten Stützwand (211) zugewandten Seite des Anzeigeabschnitts (31) angeordnet ist und der Bindungsabschnitt (32) mit dem Anzeigeabschnitt (31) und der flexiblen gedruckten Schaltung (35) elektrisch verbunden ist.

5. Elektronische Vorrichtung (10) nach Anspruch 4, wobei die elektronische Vorrichtung (10) ferner den Kühlkörper (70) umfasst und der Kühlkörper (70) zumindest teilweise zwischen der ersten Stützwand (211) und der flexiblen gedruckten Schaltung (35) angeordnet ist.

6. Elektronische Vorrichtung (10) nach Anspruch 5, wobei eine Fläche einer orthogonalen Projektion des Kühlkörpers (70) auf die erste Stützwand (211) S beträgt, wobei die orthogonale Projektion des Kühlkörpers (70) auf die erste Stützwand (211) und eine orthogonale Projektion der flexiblen gedruckten Schaltung (35) auf die erste Stützwand (211) einen Überlappungsbereich bilden und eine Fläche des Überlappungsbereichs größer als oder gleich S/2 ist.

7. Elektronische Vorrichtung (10) nach Anspruch 5 oder 6, wobei die flexible gedruckte Schaltung (35) ein Substrat (351) und ein elektronisches Bauteil (352) umfasst, und eine orthogonale Projektion des elektronischen Bauteils (352) auf die erste Stützwand (211) nicht mit der orthogonalen Projektion des Kühlkörpers (70) auf die erste Stützwand (211) überlappt.

8. Elektronische Vorrichtung (10) nach Anspruch 2, 5, 6 oder 7, wobei die erste Stützwand (211) ferner einen zweiten Aufnahmeabschnitt (211b) umfasst und sich der Kühlkörper (70) zumindest teilweise in dem zweiten Aufnahmeabschnitt (211b) befindet.

9. Elektronische Vorrichtung (10) nach Anspruch 8, wobei der zweite Aufnahmeabschnitt (211b) die erste Stützwand (211) durchdringt und ein Randbereich des Kühlkörpers (70) mit der ersten Stützwand (211) verbunden ist.

10. Elektronische Vorrichtung (10) nach einem der Ansprüche 4 bis 9, wobei die elektronische Vorrichtung (10) ferner eine erste Leiterplatte (80) umfasst, die erste Leiterplatte (80) in dem ersten Rahmen (21) angeordnet ist, die erste Leiterplatte (80) sich auf einer von dem Anzeigeabschnitt (31) abgewandten Seite der ersten Stützwand (211) befindet, die flexible gedruckte Schaltung (35) elektrisch mit der ersten Leiterplatte (80) verbunden ist, die flexible gedruckte Schaltung (35) das Substrat (351) und das elektronische Bauteil (352) umfasst, und orthogonale Projektionen von mindestens einigen elektronischen Bauteilen auf die erste Stützwand (211) nicht mit einer orthogonalen Projektion der ersten Leiterplatte (80) auf die erste Stützwand (211) überlappen.

11. Elektronische Vorrichtung (10) nach einem der Ansprüche 4 bis 10, wobei die elektronische Vorrichtung (10) ferner ein Rückkamera-Modul (50) umfasst, das Rückkamera-Modul (50) auf der von dem Anzeigeabschnitt (31) abgewandten Seite der ersten Stützwand (211) angeordnet ist, die flexible gedruckte Schaltung (35) das Substrat (351) und das elektronische Bauteil (352) umfasst, und das elektronische Bauteil (352) zwischen dem Anzeigeabschnitt (31) und dem Rückkamera-Modul (50) angeordnet ist.

12. Elektronische Vorrichtung (10) nach einem der Ansprüche 4 bis 11, wobei die elektronische Vorrichtung (10) ferner ein Frontkamera-Modul (60) umfasst, das Frontkamera-Modul (60) in dem ersten Rahmen (21) angeordnet ist, die erste Anzeige (30) einen Lichtdurchlassabschnitt (36) umfasst, der Lichtdurchlassabschnitt (36) entsprechend dem Frontkamera-Modul (60) angeordnet ist, und die orthogonale Projektion der flexiblen gedruckten Schaltung (35) auf die erste Stützwand (211) nicht mit einer orthogonalen Projektion des Lichtdurchlassabschnitts (36) auf die erste Stützwand (211) überlappt.

13. Elektronische Vorrichtung (10) nach einem der Ansprüche 1 bis 12, wobei der Anzeigeabschnitt (31) einen Randbereich umfasst, der sich auf dem ersten Rahmen (21) befindet und der weit von dem Scharnier (23) entfernt ist, und der Randbereich des Anzeigeabschnitts (31) mit dem Bindungsabschnitt (32) verbunden ist.

## Revendications

1. Dispositif électronique (10), comprenant au moins ce qui suit :
un boîtier (20), comprenant un premier cadre (21), un second cadre (22), et une charnière (23), dans lequel la charnière (23) est reliée au premier cadre (21) et au second cadre (22), le premier cadre (21) comprend une première paroi de support (211), et le second cadre (22) comprend une seconde paroi de support (221) ;
un premier écran (30), comprenant une partie d'affichage (31), une partie de liaison (32), et une puce pilote (33), dans lequel la partie d'affichage (31) est reliée à la première paroi de support (211) et à la seconde paroi de support (221), la partie de liaison (32) est disposée dans le premier cadre (21), la puce pilote (33) est disposée dans la partie de liaison (32), et la partie de liaison (32) est au moins partiellement disposée entre la première paroi de support (211) et la partie d'affichage (31) ;
un second écran (40), disposé dans le second cadre (22) ; et
une batterie (300), disposée dans le premier cadre (21), dans lequel la batterie (300) est disposée sur un côté de la première paroi de support (211) opposé à la partie d'affichage (31) ; dans lequel
lorsque le premier cadre (21) et le second cadre (22) sont dans un état plié, la partie d'affichage (31) est située entre le premier cadre (21) et le second cadre (22), et le second écran (40) est situé sur un côté du second cadre (22) opposé au premier cadre (21), et lorsque le premier cadre (21) et le second cadre (22) sont dans un état déplié, la partie d'affichage (31) est dépliée ;
la puce pilote (33) est disposée sur un côté de la partie de liaison (32) faisant face à la première paroi de support (211), la première paroi de support (211) comprend une première partie de logement (211a), et la première partie de logement (211a) contourne la puce pilote (33) ;
la première partie de logement (211a) traverse la première paroi de support (211), le premier cadre (21) comprend en outre une pièce de séparation (213) configurée pour séparer la puce pilote (33) de la batterie (300), la pièce de séparation (213) est disposée en correspondance avec la puce pilote (33), la pièce de séparation (213) est au moins partiellement située dans la première partie de logement (211a), et la pièce de séparation (213) est reliée à la première paroi de support (211) ; et
la première paroi de support (211) comprend une surface de support inclinée (211d) au niveau d'un bord de la première paroi de support (211) qui est éloigné de la charnière (23), et la surface de support inclinée (211d) est disposée en correspondance avec une section courbée (32a) de la partie de liaison (32) pour supporter la section courbée (32a).

2. Dispositif électronique (10) selon la revendication 1, dans lequel le dispositif électronique (10) comprend en outre un dissipateur de chaleur (70), le dissipateur de chaleur (70) est relié à la première paroi de support (211), et il existe un premier espacement entre le dissipateur de chaleur (70) et la puce pilote (33).

3. Dispositif électronique (10) selon la revendication 2, dans lequel le dissipateur de chaleur (70) est disposé face à la partie d'affichage (31).

4. Dispositif électronique (10) selon l'une quelconque des revendications 1 à 3, dans lequel le premier écran (30) comprend en outre un circuit imprimé flexible (35), le circuit imprimé flexible (35) est disposé sur un côté de la partie d'affichage (31) faisant face à la première paroi de support (211), et la partie de liaison (32) est connectée électriquement à la partie d'affichage (31) et au circuit imprimé flexible (35).

5. Dispositif électronique (10) selon la revendication 4, dans lequel le dispositif électronique (10) comprend en outre le dissipateur de chaleur (70), et le dissipateur de chaleur (70) est au moins partiellement disposé entre la première paroi de support (211) et le circuit imprimé flexible (35).

6. Dispositif électronique (10) selon la revendication 5, dans lequel une aire d'une projection orthographique du dissipateur de chaleur (70) sur la première paroi de support (211) est S, la projection orthographique du dissipateur de chaleur (70) sur la première paroi de support (211) et une projection orthographique du circuit imprimé flexible (35) sur la première paroi de support (211) forment une zone de chevauchement, et une aire de la zone de chevauchement est supérieure ou égale à S/2.

7. Dispositif électronique (10) selon la revendication 5 ou 6, dans lequel le circuit imprimé flexible (35) comprend un substrat (351) et un composant électronique (352), et une projection orthographique du composant électronique (352) sur la première paroi de support (211) ne chevauche pas la projection orthographique du dissipateur de chaleur (70) sur la première paroi de support (211).

8. Dispositif électronique (10) selon la revendication 2, 5, 6, ou 7, dans lequel la première paroi de support (211) comprend en outre une seconde partie de logement (211b), et le dissipateur de chaleur (70) est au moins partiellement situé dans la seconde partie de logement (211b).

9. Dispositif électronique (10) selon la revendication 8, dans lequel la seconde partie de logement (211b) pénètre à travers la première paroi de support (211), et une zone de bord du dissipateur de chaleur (70) est reliée à la première paroi de support (211).

10. Dispositif électronique (10) selon l'une quelconque des revendications 4 à 9, dans lequel le dispositif électronique (10) comprend en outre une première carte de circuit imprimé (80), la première carte de circuit imprimé (80) est disposée dans le premier cadre (21), la première carte de circuit imprimé (80) est située sur un côté de la première paroi de support (211) opposé à la partie d'affichage (31), le circuit imprimé flexible (35) est connecté électriquement à la première carte de circuit imprimé (80), le circuit imprimé flexible (35) comprend le substrat (351) et le composant électronique (352), et des projections orthographiques d'au moins certains composants électroniques sur la première paroi de support (211) ne chevauchent pas une projection orthographique de la première carte de circuit imprimé (80) sur la première paroi de support (211).

11. Dispositif électronique (10) selon l'une quelconque des revendications 4 à 10, dans lequel le dispositif électronique (10) comprend en outre un module de caméra orienté vers l'arrière (50), le module de caméra orienté vers l'arrière (50) est disposé sur le côté de la première paroi de support (211) opposé à la partie d'affichage (31), le circuit imprimé flexible (35) comprend le substrat (351) et le composant électronique (352), et le composant électronique (352) est disposé entre la partie d'affichage (31) et le module de caméra orienté vers l'arrière (50).

12. Dispositif électronique (10) selon l'une quelconque des revendications 4 à 11, dans lequel le dispositif électronique (10) comprend en outre un module de caméra orienté vers l'avant (60), le module de caméra orienté vers l'avant (60) est disposé dans le premier cadre (21), le premier écran (30) comprend une partie transmettant la lumière (36), la partie transmettant la lumière (36) est disposée en correspondance avec le module de caméra orienté vers l'avant (60), et la projection orthographique du circuit imprimé flexible (35) sur la première paroi de support (211) ne chevauche pas une projection orthographique de la partie transmettant la lumière (36) sur la première paroi de support (211).

13. Dispositif électronique (10) selon l'une quelconque des revendications 1 à 12, dans lequel la partie d'affichage (31) comprend une zone de bord qui est située sur le premier cadre (21) et qui est éloignée de la charnière (23), et la zone de bord de la partie d'affichage (31) est reliée à la partie de liaison (32).
